# FASCICULE DE BREVET EUROPEEN

(11) **EP 1 954 526 B1**
(45) Date de publication et mention de la délivrance du brevet: **27.01.2021**
(21) Numéro de dépôt: 06819606.2
(22) Date de dépôt: 20.11.2006
(51) Int. Cl.: F21V 33/00, F21K 9/00, B32B 17/10, E06B 3/66, H05B 33/24, E04D 3/06, G09F 13/04, G09F 13/22, A47F 11/10, A47F 3/00

(54) **PANNEAU ÉMETTEUR DE RADIATIONS LUMINEUSES**
LEUCHTPANEEL
LIGHT EMITTING PANEL

(30) Priorité: 21.11.2005 EP 05111035
(43) Date de publication de la demande: 13.08.2008
(73) Titulaire: AGC Glass Europe, 1348 Louvain-la-Neuve (BE)
(72) Inventeur: LEFEVRE, Hugues, B-6040 Jumet (BE)
(74) Mandataire: AGC Glass Europe
(86) Numéro de dépôt international: PCT/EP2006/068654
(87) Numéro de publication internationale: WO 2007/057456

(56) Documents cités:
- EP-A- 0 900 971
- EP-A- 1 437 215
- WO-A-2005/097551
- CA-A1- 2 355 416
- DE-A- 4 415 457
- DE-A1- 10 347 163
- FR-A- 2 738 783
- GB-A- 2 362 022
- US-A1- 2004 004 827
- US-A1- 2004 040 228
- PATENT ABSTRACTS OF JAPAN vol. 015, no. 442 (E-1131), 11 novembre 1991 (1991-11-11) & JP 03 187186 A (MATSUSHITA ELECTRIC IND CO LTD), 15 août 1991 (1991-08-15)
- PATENT ABSTRACTS OF JAPAN vol. 016, no. 451 (P-1424), 18 septembre 1992 (1992-09-18) & JP 04 159519 A (STANLEY ELECTRIC CO LTD), 2 juin 1992 (1992-06-02)
- PATENT ABSTRACTS OF JAPAN vol. 2003, no. 12, 5 décembre 2003 (2003-12-05) & JP 2003 234178 A (MATSUSHITA ELECTRIC IND CO LTD), 22 août 2003 (2003-08-22)
- PATENT ABSTRACTS OF JAPAN vol. 1996, no. 09, 30 septembre 1996 (1996-09-30) & JP 08 129343 A (HITACHI MEDIA ELECTRON:KK), 21 mai 1996 (1996-05-21)

## Description

La présente invention concerne un panneau en verre fournissant des radiations lumineuses générées par des composants électroniques dans lequel la densité des radiations est bien répartie sur l'ensemble de la surface du panneau.

Dans le cadre des panneaux en verre fournissant des radiations lumineuses, on connait tout d'abord des panneaux de pare-brises automobiles auxquels sont solidarisés des dispositifs de signalisation à base de LEDs tels que décrit dans les documents WO2005/097551A1 et FR2738783 par exemple.

On connaît également un dispositif d'éclairage comprenant un panneau de support transparent en verre revêtu de bandes conductrices de l'électricité sur lesquelles sont montées des diodes électroluminescentes émettant leur lumière au travers du support transparent (brevet US 6,270,236 B1).

Ce dispositif connu apparaît toutefois comme un panneau formé d'une multitude de points lumineux très brillants au droit des diodes luminescentes séparées par des zones noires ou très sombres. Il en résulte un effet peu propice à l'utilisation du panneau dans les applications d'éclairage ou de décoration.

L'invention remédie à cet inconvénient en fournissant un panneau en verre comprenant une multitude de composants électroniques générant des radiations lumineuses qui répartit bien la densité des radiations sur l'ensemble de la surface du panneau.

A cet effet, l'invention concerne un panneau émetteur de radiations lumineuses tel que défini dans la revendication 1.

Les revendications dépendantes définissent d'autres formes possibles de réalisation de l'invention, dont certaines sont préférées.

Outre la forte diminution, voire l'absence d'effet d'éblouissement déjà mentionné, l'invention peut aussi apporter un ou plusieurs des avantages suivants :
- meilleure répartition de la densité du rayonnement sur l'étendue de la surface du panneau ;
- possibilité de réduction du nombre de composants émetteurs de radiations ;
- simplification du système d'alimentation électrique des composants ;
- amélioration de l'esthétique du panneau.

Le panneau émetteur de radiations lumineuses selon l'invention est composé d'au moins une feuille de verre. Par feuille de verre, on entend désigner toute plaque de verre d'épaisseur pouvant varier entre 1 et 50 mm. L'épaisseur peut varier en différents points de la surface de la feuille. La surface peut être plane ou courbe. On préfère cependant des feuilles de verre planes d'épaisseur constante en tout point de la surface. Le verre peut être constitué indifféremment d'un ou plusieurs types de verres connus comme les verres sodo-calcique, les verres au bore, les verres cristallins et semi-cristallins, les verres opalins. La couleur du verre peut être neutre (verres transparents ou gris) ou plus ou moins saturée (coloration dans la masse ou en surface par une teinte pouvant aller du rouge au violet). La couleur peut être uniformément répartie sur toute la surface de la feuille ou, au contraire être localisée en une ou plusieurs zones particulières de la surface du panneau. Des feuilles de verre uniformément neutres ou colorées uniformément sur toute la surface ou la masse des feuilles sont préférées. Le verre de la feuille peut également être transparent ou au contraire, plus ou moins filtrant pour les radiations lumineuses situées en deçà et au-delà des fréquences du spectre visible.

Le panneau conforme à l'invention est aussi composé d'une pluralité de composants électroniques qui génèrent des radiations lumineuses. Par radiations lumineuses, on entend celles qui appartiennent au spectre visible. Ces radiations peuvent être parfaitement monochromatiques ou, au contraire, se distribuer sur une ou plusieurs bandes de fréquences, contiguës ou non. Ces composants peuvent être choisis parmi les divers composants électroniques dotés de propriétés optoélectroniques ainsi que des composants capables d'émettre des radiations étrangères à celles peuplant le spectre visible, éventuellement avec des radiations appartenant à ce spectre. Ce sont par exemple des diodes LED émettant dans le spectre visible, des diodes UV et/ou visible et/ou IR.

Selon l'invention, ces composants sont disposés à l'intérieur du panneau, c'est-à-dire qu'ils sont disposés sur une surface interne au panneau qui n'a pas de contact avec son environnement externe.

Le panneau comprend un assemblage d'au moins une structure émettrice avec au moins une structure réfléchissante. Par structure émettrice, on entend toute structure comprenant la ou les feuilles de verre et les composants électroniques. Par structure réfléchissante, on désigne toute structure capable de réfléchir au moins une partie des rayonnements émis par la structure émettrice. La réflexion des radiations émises peut être totale ou partielle, le reste du rayonnement étant absorbé par et/ou transmis au travers de la structure réfléchissante.

On préfère généralement des structures réfléchissantes qui présentent un facteur de réflexion lumineuse allant de 35 à 95 %.

Des exemples de structures émettrices préférées sont des feuilles de verre planes portant les composants électroniques sur leur surface. Les structures réfléchissantes sont des miroirs parallèles aux structures émettrices. Dans ces panneaux, un vide rempli ou non d'atmosphère ambiante peut être interposé entre les structures émettrices et les structures réfléchissantes. Alternativement, les structures émettrices et réfléchissantes peuvent être en contact l'une avec l'autre, directement ou via l'interposition d'une ou plusieurs feuilles de matière plastique ou de feuilles de verre supplémentaires.

Selon l'invention, la structure émettrice est pourvue de moyens de solidarisation avec la structure réfléchissante. Ces moyens peuvent être divers et variés. Ils peuvent, par exemple, être constitués de cadres en bois, en métal, enfermant les bords des structures émettrices et réfléchissantes de sorte à rigidifier l'ensemble en une seule pièce composite. De préférence, les structures émettrices et réfléchissante sont disposées espacées les unes des autres d'au moins 0,5 cm en tout point de leurs surfaces. Les moyens de solidarisation peuvent encore, alternativement, être réalisés, par exemple par collage ou par fusion d'une ou plusieurs feuilles intercalaires en plastique et/ou en verre sur chacune des surfaces des structures émettrices et réfléchissantes se faisant vis-à-vis de manière jointive les unes contre les autres. On peut aussi combiner au moins un cadre et au moins une feuille intercalaire.

Dans une première forme de réalisation préférée du panneau conforme à l'invention, les composants électroniques comprennent des générateurs directionnels de radiations. De préférence on oriente ces composants de manière à émettre les radiations dans la direction de la structure réfléchissante. De manière encore plus préférée, la direction des radiations est réalisée perpendiculaire ou proche de la perpendiculaire à la surface de la structure réfléchissante.

Selon la forme de réalisation préférée du panneau conforme à l'invention, la structure réfléchissante est un miroir sélectionné parmi ceux qui sont constitués d'un élément comprenant une surface métallique réfléchissante ou d'une surface présentant une couleur claire ou blanche. Plus préférés encore sont les panneaux comprenant un miroir dont la surface métallique réfléchissante est une surface d'un film métallique déposé sur au moins une feuille de verre. Le métal du film est avantageusement de l'argent ou un alliage d'argent. Le film métallique peut être placé sur la feuille de verre du côté incident du rayonnement et son épaisseur peut généralement aller de 70 à 120 nm.

Une autre forme de réalisation d'un miroir dans le panneau conforme à l'invention est celle dans laquelle au moins une feuille de verre du miroir est munie d'au moins un moyen de dispersion d'au moins une partie des rayonnements lumineux. Ce moyen de dispersion peut être choisi parmi le matage de la surface de cette feuille de verre, le sablage de cette feuille ou encore l'impression d'un relief sur sa surface opposée à celle du film métallique réfléchissant les rayonnements. Le matage peut avoir été réalisé au moyen d'une solution aqueuse d'acide fluorhydrique, par exemple.

Dans cette forme avantageuse de réalisation du panneau compatible avec la forme précédente, le film métallique du miroir peut être disposé sur la surface de la feuille de verre du miroir opposée à celle recevant le rayonnement lumineux, afin de réaliser une certaine diffusion du rayonnement lumineux réfléchi.

Une autre forme particulièrement préférée du panneau selon l'invention, compatible avec toutes les formes de réalisation précédentes, est celle dans laquelle une structure diffusante est ajoutée à une des extrémités de l'assemblage, du côté opposé à celui de la structure réfléchissante par rapport à la structure émettrice.

De préférence, dans cette dernière forme de réalisation, on choisit des moyens de solidarisation qui maintiennent les structure diffusantes, émettrices et réfléchissantes substantiellement parallèles et espacées les unes des autres d'au moins 0,5 cm en tout point de leur surface.

Avantageusement, dans cette dernière forme de réalisation, la structure diffusante est constituée d'une feuille de verre unique matée, sablée ou imprimée en relief sur au moins une de ses deux faces.

Alternativement, la structure diffusante peut aussi ou peut en outre être réalisée au moyen d'un verre laminé comprenant au moins deux feuilles de verre pressées de part et d'autre d'au moins une feuille en matière plastique diffusante ou d'une couche de fibres de verre non tissées. La matière plastique peut avoir été choisie parmi les polyesters, par exemple le polyvinylbutyral, les copolymères d'éthylène et d'acétate de vinyle et les polyéthylènetéréphtalates.

Une variante intéressante est celle dans laquelle la structure diffusante se confond avec la structure réfléchissante, par exemple dans le cas du placement du film métallique au dos de la feuille de verre par rapport au rayonnement lumineux incident décrit plus haut, dans les cas où ce placement particulier du film métallique agit également comme moyen de dispersion des rayonnements lumineux.

Dans la forme de réalisation du panneau conforme aux revendications, les radiations lumineuses générées par les composants électroniques ont une longueur d'onde appartenant au spectre visible. Les radiations lumineuses peuvent aussi avantageusement comprendre au moins une partie du spectre visible et au moins une partie du spectre infrarouge et/ou ultraviolet. De préférence encore, les composants électroniques sont des LED's.

Dans cette dernière forme de réalisation, les LED's sont avantageusement alimentées en courant électrique au moyen d'une couche translucide conductrice déposée sur la feuille de verre de la structure émettrice sur laquelle se trouvent les LED's. De préférence, des zones ont été isolées du reste de la couche conductrice par de fines bandes isolantes.

Alternativement aux zones conductrices, les LED's peuvent aussi être alimentées au moyen d'un treillis de fils conducteurs.

Des panneaux émetteurs de radiations lumineuses selon l'invention vont maintenant être décrits en détail au moyen d'exemples illustrant l'invention, sans chercher cependant à en limiter la portée.

### Exemple 1 : Panneau d'éclairage comprenant des LED's et un miroir de fond

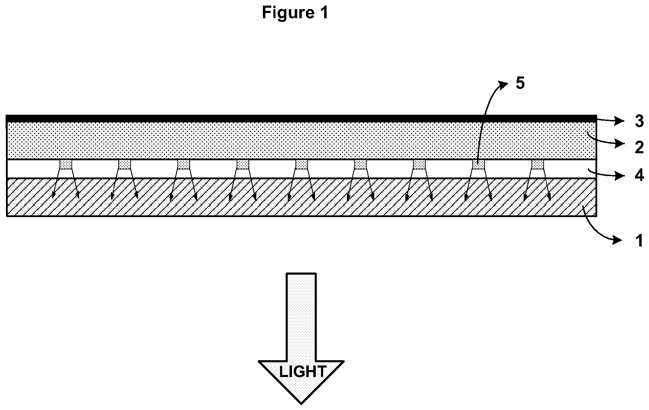

La figure 1 montre un panneau comprenant une feuille de verre clair transparent (1) de 3,15 mm d'épaisseur et un miroir traditionnel composé d'une autre feuille de verre (2) de 4mm d'épaisseur portant sur une de ses faces un film métallique (3) d'argent (argenture habituelle) de 70 à 120 nm d'épaisseur. Le film d'argent (3) est protégé contre la corrosion sur sa face externe par deux minces couches de peinture appropriée d'environ 50 µm chacune, comme dans les miroirs traditionnels.

Prise en sandwich entre les deux feuilles de verre, on trouve une couche de polyvinylbutyral (PVB) (4) de teinte claire de 0,76 mm d'épaisseur. Des LED's (5) de marque NICHIA® Warm White et de type NFSL036 sont en contact avec la feuille de verre (2) et sont insérées dans la couche (4) de PVB à distance régulière de 55 mm dans les deux dimensions.

Les LED's (5) sont alimentées par des bandes conductrices minces de 400 nm d'épaisseur et de largeur légèrement inférieure à 55 mm, qui recouvrent la surface du verre (2). Elles fournissent un flux lumineux s'étendant sur le spectre visible et qui traverse la feuille de verre transparent (1).

L'ensemble du miroir (2, 3), des LED's (5), de la couche de PVB (4) et de la feuille de verre transparent (1) est assemblé mécaniquement par les forces d'adhésion unissant les feuilles de verre (1, 2) avec la couche de PVB (4).

Cet assemblage offre l'avantage de récupérer toute la lumière provenant des LED's (5) qui peut atteindre le film métallique (3) du miroir disposé au fond de l'assemblage et celui de rediriger cette lumière vers la surface éclairante du panneau constituée par la feuille de verre (1).

### Exemple 2 : Panneau décoratif fournissant une lumière uniforme

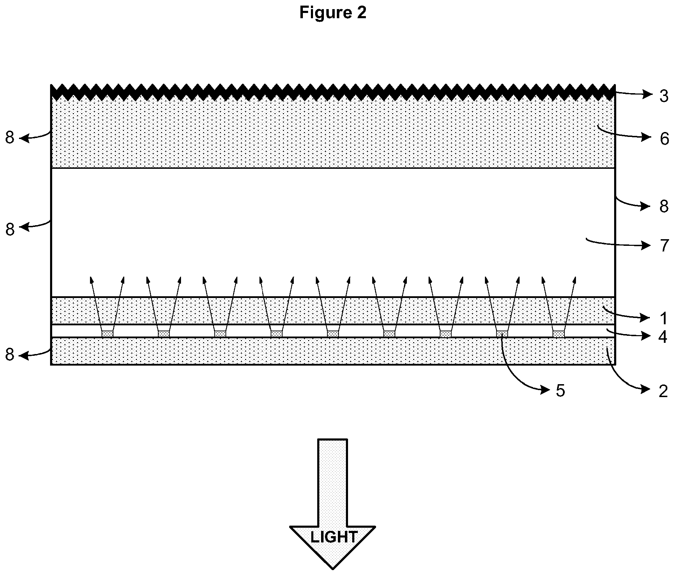

La figure 2 illustre un panneau fournissant une lumière encore mieux répartie uniformément sur l'ensemble de sa surface inférieure. Celle-ci est constituée d'une structure émettrice comprenant deux feuilles de verre clair transparent (1, 2) de respectivement 3 et 3,15 mm d'épaisseur, séparées par une couche de polyvinylbutyral (PVB) (4) de teinte claire de 0,76 mm d'épaisseur. Des LED's (5) de marque NICHIA® Warm White et de type NFSL036, émettant dans le spectre de la lumière visible, sont insérées dans la couche (4) de PVB à distance régulière de 100 mm dans les deux dimensions. Les LED's (5) sont en outre disposées dans cette structure émettrice de façon à diriger leur flux lumineux vers l'intérieur du panneau, au travers de la feuille (1) de verre clair transparent. Elles sont alimentées par des bandes conductrices d'environ 100 mm de large, comme à l'exemple précédent.

De plus, un verre imprimé (6) est disposé à une distance de 3 cm de la structure émettrice. Il présente une face lisse en regard de cette structure émettrice et une surface imprimée régulière du côté externe au panneau. La surface imprimée externe est recouverte d'une argenture (3) et d'une peinture de protection, analogues à celles d'un miroir. L'ensemble verre imprimé (6) et argenture peinte (3) forment une structure réfléchissante et diffusante du rayonnement lumineux. Un cadre (8) en bois rigidifie l'assemblage des structures et détermine l'espace (7) de 3 cm de largeur entre celles-ci. L'espace (7) est occupé par de l'air ambiant.

### Exemple 3 : Panneau décoratif fournissant une lumière uniforme

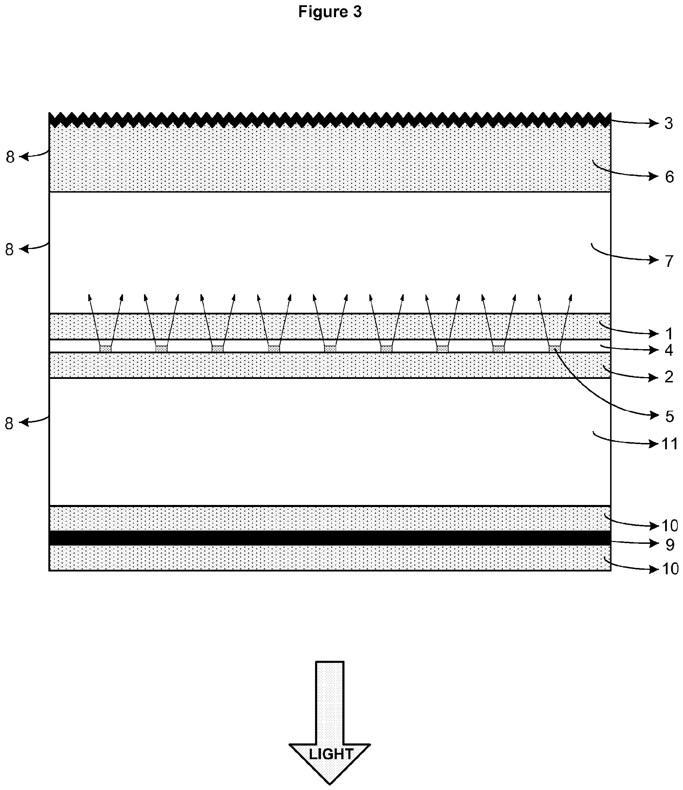

Un panneau fournissant une lumière encore mieux répartie uniformément sur toute sa surface éclairante est décrit à la figure 3.

A cette figure on peut remarquer les mêmes structures émettrice et réfléchissante qu'à l'exemple 2 précédent séparées par un espace identique de 3 cm. Les LED's (5) sont encore alimentées de la même manière qu'à l'exemple 2 précédent.

Ces structures ont été complétées dans cet exemple par une structure supplémentaire diffusante formée d'une couche (9) de PVB opaque de couleur blanche de 0,76 mm d'épaisseur enserrée entre deux feuilles de verre clair transparent (10).

Ici encore, un cadre (8) en bois rigidifie l'assemblage des structures émettrice, réfléchissante et diffusante et détermine les espace (7) et (11) de chacun 3 cm de largeur entre chacune des trois structures. Les espaces (7) et (11) sont encore occupés par de l'air ambiant.

### Exemple 4 : Panneau décoratif fournissant une lumière uniforme

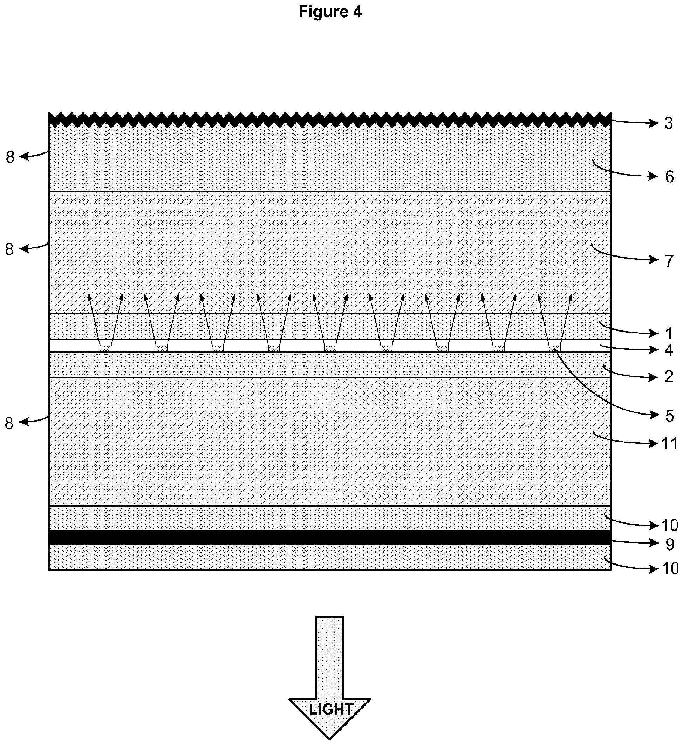

A la figure 4, on illustre une variante d'un panneau fournissant une lumière répartie uniformément sur l'ensemble de sa surface inférieure identique en tous points à celui décrit à l'exemple 3 précédent, à ceci près que les espaces (7) et (11) ne sont ici plus occupés par de l'air ambiant mais sont matérialisés par des plaques de verre clair épais et transparent de chacune 2,5 cm d'épaisseur. Ces plaques sont disposées jointives avec chaque fois deux des trois structures.

## Revendications

1. Panneau émetteur de radiations lumineuses composé d'au moins une feuille de verre et d'une pluralité de composants électroniques capables de générer des radiations lumineuses, les composants étant disposés à l'intérieur du panneau, **caractérisé en ce que** le panneau comprend un assemblage :
• d'au moins une structure émettrice renfermant une ou plusieurs feuilles de verre et les composants électroniques
• avec au moins une structure réfléchissante du rayonnement lumineux, ladite structure réfléchissante étant constituée par un miroir,
la structure émettrice étant pourvue de moyens de solidarisation mécanique avec la structure réfléchissante, les moyens de solidarisation maintenant les structures émettrices et réfléchissantes substantiellement parallèles et la densité des radiations lumineuses générées par les composants électroniques étant bien répartie sur l'ensemble de la surface du panneau, les radiations lumineuses étant des radiations du spectre visible.

2. Panneau émetteur de radiations lumineuses selon la revendication 1, **caractérisé en ce que** les composants électroniques comprennent des générateurs directionnels de radiations lumineuses qui envoient leurs rayons vers la structure réfléchissante.

3. Panneau émetteur de radiations lumineuses selon l'une quelconque des revendications 1 et 2, **caractérisé en ce que** le miroir est sélectionné parmi ceux qui sont constitués d'un élément comprenant une surface métallique réfléchissante ou d'une surface présentant une couleur claire ou blanche.

4. Panneau émetteur de radiations lumineuses selon la revendication 3, **caractérisé en ce que** la surface métallique réfléchissante est une surface d'un film métallique déposé sur au moins une feuille de verre.

5. Panneau émetteur de radiations lumineuses selon la revendication 4, **caractérisé en ce que** le métal du film est de l'argent ou un alliage d'argent.

6. Panneau émetteur de radiations lumineuses selon la revendication 4 ou 5, **caractérisé en ce que** le film métallique est disposé sur la surface de la feuille de verre du miroir opposée à celle recevant le rayonnement lumineux.

7. Panneau émetteur de radiations lumineuses selon une quelconque des revendications 1 à 6, **caractérisé en ce que** les structures émettrices et les structures réfléchissantes sont disposées de manière jointive, les unes contre les autres.

8. Panneau émetteur de radiations lumineuses selon une quelconque des revendications 1 à 6, **caractérisé en ce que** les structures émettrices et les structures réfléchissantes sont disposées espacées les unes des autres d'au moins 0,5 cm en tout point de leurs surfaces.

9. Panneau émetteur de radiations lumineuses selon une quelconque des revendications 1 à 8, **caractérisé en ce qu'**au moins une feuille de verre du miroir est munie d'au moins un moyen de dispersion d'au moins une partie des rayons lumineux.

10. Panneau émetteur de radiations lumineuses selon la revendication 9, **caractérisé en ce que** le moyen de dispersion est constitué par un matage, un sablage ou une impression de la surface par un relief supprimant le caractère poli de la surface de verre pourvue du moyen de dispersion.

11. Panneau émetteur de radiations lumineuses selon la revendication 10, **caractérisé en ce qu'**au moins une feuille de verre du miroir est munie d'une surface imprimée en relief sur la face opposée à celle du film métallique réfléchissant les rayonnements.

12. Panneau émetteur de radiations lumineuses selon une quelconque des revendications 1 à 11, **caractérisé en ce qu'**une structure diffusante est en outre disposée à une des extrémités de l'assemblage, du côté opposé à celui de la structure réfléchissante par rapport à la structure émettrice.

13. Panneau émetteur de radiations lumineuses selon la revendication 12, **caractérisé en ce que** les moyens de solidarisation maintiennent les structures diffusantes, émettrices et réfléchissantes substantiellement parallèles et espacées les unes des autres d'au moins 0,5 cm en tout point de leurs surfaces adjacentes.

14. Panneau émetteur de radiations lumineuses selon la revendication 12 ou 13, **caractérisé en ce que** la structure diffusante est constituée d'une feuille de verre unique matée, sablée ou imprimée en relief sur au moins une de ses deux faces.

15. Panneau émetteur de radiations lumineuses selon une quelconque des revendications 12 à 14, **caractérisé en ce que** la structure diffusante est constituée de verre laminé comprenant au moins deux feuilles de verre pressées de part et d'autre d'au moins une feuille en matière plastique diffusante ou d'une couche de fibres de verre non tissées.

16. Panneau émetteur de radiations lumineuses selon la revendication 15, **caractérisé en ce que** la matière plastique est choisie parmi le polyvinylbutyral, les copolymères d'éthylène et d'acétate de vinyle et les polyéthylènetéréphtalates.

17. Panneau émetteur de radiations lumineuses selon une quelconque des revendications 12 à 16, **caractérisé en ce que** la structure diffusante se confond avec la structure réfléchissante.

18. Panneau émetteur de radiations lumineuses selon une quelconque des revendications 1 à 17, **caractérisé en ce que** les composants électroniques sont des diodes électroluminescentes ou « LED's ».

19. Panneau émetteur de radiations lumineuses selon la revendication 18, **caractérisé en ce que** les LED's sont alimentées au moyen d'une couche translucide conductrice déposée sur la feuille de verre de la structure émettrice sur laquelle se trouvent les LED's.

20. Panneau émetteur de radiations lumineuses selon la revendication 19, **caractérisé en ce que** des zones ont été isolées du reste de la couche conductrice par de fines bandes isolantes.

21. Panneau émetteur de radiations lumineuses selon la revendication 18, **caractérisé en ce que** les LED's sont alimentées au moyen d'un treillis de fils conducteurs.

## Patentansprüche

1. Lichtstrahlen emittierendes Paneel, welches aus wenigstens einer Glasscheibe und mehreren elektronischen Bauteilen, die in der Lage sind, Lichtstrahlen zu erzeugen, besteht, wobei die Bauteile im Inneren des Paneels angeordnet sind, **dadurch gekennzeichnet, dass** das Paneel eine Anordnung umfasst:
• aus wenigstens einer emittierenden Struktur, die eine oder mehrere Glasscheiben und die elektronischen Bauteile umfasst,
• mit wenigstens einer die Lichtstrahlen reflektierenden Struktur, wobei die reflektierende Struktur aus einem Spiegel besteht,
wobei die emittierende Struktur mit Mitteln zur festen mechanischen Verbindung mit der reflektierenden Struktur versehen ist, wobei die Mittel zur festen Verbindung die emittierenden und reflektierenden Strukturen im Wesentlichen parallel halten und die Dichte der von den elektronischen Bauteilen erzeugten Lichtstrahlen gut über die gesamte Fläche des Paneels verteilt ist, wobei die Lichtstrahlen Strahlen des sichtbaren Spektrums sind.

2. Lichtstrahlen emittierendes Paneel nach Anspruch 1, **dadurch gekennzeichnet, dass** die elektronischen Bauteile gerichtete Erzeuger von Lichtstrahlen umfassen, welche ihre Strahlen in Richtung der reflektierenden Struktur senden.

3. Lichtstrahlen emittierendes Paneel nach einem der Ansprüche 1 und 2, **dadurch gekennzeichnet, dass** der Spiegel aus denjenigen ausgewählt ist, welche aus einem Element bestehen, das eine reflektierende metallische Oberfläche oder eine Oberfläche, die eine helle oder weiße Farbe aufweist, umfasst.

4. Lichtstrahlen emittierendes Paneel nach Anspruch 3, **dadurch gekennzeichnet, dass** die reflektierende metallische Oberfläche eine Oberfläche eines Metallfilms ist, der auf wenigstens eine Glasscheibe aufgebracht ist.

5. Lichtstrahlen emittierendes Paneel nach Anspruch 4, **dadurch gekennzeichnet, dass** das Metall des Films Silber oder eine Silberlegierung ist.

6. Lichtstrahlen emittierendes Paneel nach Anspruch 4 oder 5, **dadurch gekennzeichnet, dass** der Metallfilm auf der Oberfläche der Glasscheibe des Spiegels angeordnet ist, die derjenigen gegenüberliegt, welche die Lichtstrahlen empfängt.

7. Lichtstrahlen emittierendes Paneel nach einem der Ansprüche 1 bis 6, **dadurch gekennzeichnet, dass** die emittierenden Strukturen und die reflektierenden Strukturen aneinander anliegend angeordnet sind.

8. Lichtstrahlen emittierendes Paneel nach einem der Ansprüche 1 bis 6, **dadurch gekennzeichnet, dass** die emittierenden Strukturen und die reflektierenden Strukturen in jedem Punkt ihrer Oberflächen um mindestens 0,5 cm voneinander beabstandet angeordnet sind.

9. Lichtstrahlen emittierendes Paneel nach einem der Ansprüche 1 bis 8, **dadurch gekennzeichnet, dass** wenigstens eine Glasscheibe des Spiegels mit wenigstens einem Mittel zur Streuung wenigstens eines Teils der Lichtstrahlen versehen ist.

10. Lichtstrahlen emittierendes Paneel nach Anspruch 9, **dadurch gekennzeichnet, dass** das Mittel zur Streuung aus einer Mattierung, einer Sandstrahlung oder einer Prägung der Oberfläche mit einem Relief besteht, die den polierten Charakter der mit dem Mittel zur Streuung versehenen Glasoberfläche beseitigt.

11. Lichtstrahlen emittierendes Paneel nach Anspruch 10, **dadurch gekennzeichnet, dass** wenigstens eine Glasscheibe des Spiegels mit einer geprägten Oberfläche auf der Seite versehen ist, die derjenigen des die Strahlen reflektierenden Metallfilms gegenüberliegt.

12. Lichtstrahlen emittierendes Paneel nach einem der Ansprüche 1 bis 11, **dadurch gekennzeichnet, dass** außerdem eine lichtstreuende Struktur an einem der Enden der Anordnung angeordnet ist, auf der Seite, die, bezogen auf die emittierende Struktur, derjenigen der reflektierende Struktur gegenüberliegt.

13. Lichtstrahlen emittierendes Paneel nach Anspruch 12, **dadurch gekennzeichnet, dass** die Mittel zur festen Verbindung die lichtstreuenden, emittierenden und reflektierenden Strukturen so halten, dass sie im Wesentlichen parallel sind und in jedem Punkt ihrer benachbarten Oberflächen um mindestens 0,5 cm voneinander beabstandet sind.

14. Lichtstrahlen emittierendes Paneel nach Anspruch 12 oder 13, **dadurch gekennzeichnet, dass** die lichtstreuende Struktur aus einer einzigen Glasscheibe besteht, die auf wenigstens einer ihrer beiden Seiten mattiert, sandgestrahlt oder mit einer Prägung versehen ist.

15. Lichtstrahlen emittierendes Paneel nach einem der Ansprüche 12 bis 14, **dadurch gekennzeichnet, dass** die lichtstreuende Struktur aus Verbundglas besteht, das wenigstens zwei Glasscheiben umfasst, die beiderseits wenigstens einer Scheibe aus lichtstreuendem Kunststoffmaterial oder einer Schicht aus Glasfaservlies zusammengepresst sind.

16. Lichtstrahlen emittierendes Paneel nach Anspruch 15, **dadurch gekennzeichnet, dass** das Kunststoffmaterial aus Polyvinylbutyral, den Copolymeren von Ethylen und Vinylacetat und den Polyethylenterephthalaten ausgewählt ist.

17. Lichtstrahlen emittierendes Paneel nach einem der Ansprüche 12 bis 16, **dadurch gekennzeichnet, dass** die lichtstreuende Struktur in die reflektierende Struktur übergeht.

18. Lichtstrahlen emittierendes Paneel nach einem der Ansprüche 1 bis 17, **dadurch gekennzeichnet, dass** die elektronischen Bauteile Leuchtdioden oder "LEDS" sind.

19. Lichtstrahlen emittierendes Paneel nach Anspruch 18, **dadurch gekennzeichnet, dass** die LEDs mittels einer leitfähigen durchscheinenden Schicht mit Strom versorgt werden, die auf die Glasscheibe der emittierenden Struktur aufgebracht ist, auf der sich die LEDs befinden.

20. Lichtstrahlen emittierendes Paneel nach Anspruch 19, **dadurch gekennzeichnet, dass** Bereiche durch isolierende feine Bänder vom Rest der leitfähigen Schicht isoliert worden sind.

21. Lichtstrahlen emittierendes Paneel nach Anspruch 18, **dadurch gekennzeichnet, dass** die LEDs mittels eines Netzes aus leitfähigen Drähten mit Strom versorgt werden.

## Claims

1. Light radiation-emitting panel consisting of at least one glass sheet and of a plurality of electronic components capable of generating light radiation, the components being arranged inside the panel, **characterized in that** the panel comprises an assembly:
• of at least one emitting structure enclosing one or more glass sheets and the electronic components
• with at least one reflective structure reflecting the light radiation, said reflective structure being formed by a mirror,
the emitting structure being provided with attachment means for mechanical attachment to the reflective structure, the attachment means keeping the emitting and reflective structures substantially parallel and the density of the light radiation generated by the electronic components being well-distributed over the entire surface of the panel, the light radiation being radiation in the visible spectrum.

2. Light radiation-emitting panel according to Claim 1, **characterized in that** the electronic components comprise directional light radiation generators that send their rays towards the reflective structure.

3. Light radiation-emitting panel according to either one of Claims 1 and 2, **characterized in that** the mirror is selected from among those formed of an element comprising a reflective metal surface or a surface having a clear or white colour.

4. Light radiation-emitting panel according to Claim 3, **characterized in that** the reflective metal surface is a surface of a metal film deposited on at least one glass sheet.

5. Light radiation-emitting panel according to Claim 4, **characterized in that** the metal of the film is silver or a silver alloy.

6. Light radiation-emitting panel according to Claim 4 or 5, **characterized in that** the metal film is arranged on that surface of the glass sheet of the mirror opposite the one receiving the light radiation.

7. Light radiation-emitting panel according to any one of Claims 1 to 6, **characterized in that** the emitting structures and the reflective structures are arranged contiguously with respect to one another.

8. Light radiation-emitting panel according to any one of Claims 1 to 6, **characterized in that** the emitting structures and the reflective structures are arranged spaced from one another by at least 0.5 cm at all points of their surfaces.

9. Light radiation-emitting panel according to any one of Claims 1 to 8, **characterized in that** at least one glass sheet of the mirror is provided with at least one dispersion means for dispersing at least some of the light rays.

10. Light radiation-emitting panel according to Claim 9, **characterized in that** the dispersion means is formed by matting, sanding or relief-printing the surface so as to eliminate the polished nature of the glass surface provided with the dispersion means.

11. Light radiation-emitting panel according to Claim 10, **characterized in that** at least one glass sheet of the mirror is provided with a relief-printed surface on the face opposite that of the metal film reflecting the radiation.

12. Light radiation-emitting panel according to any one of Claims 1 to 11, **characterized in that** a scattering structure is furthermore arranged at one of the ends of the assembly, on the side opposite that of the reflective structure with respect to the emitting structure.

13. Light radiation-emitting panel according to Claim 12, **characterized in that** the attachment means keep the scattering, emitting and reflective structures substantially parallel and spaced from one another by at least 0.5 cm at all points of their adjacent surfaces.

14. Light radiation-emitting panel according to Claim 12 or 13, **characterized in that** the scattering structure is formed of a single glass sheet that is matted, sanded or relief-printed on at least one of its two faces.

15. Light radiation-emitting panel according to any one of Claims 12 to 14, **characterized in that** the scattering structure is formed of laminated glass comprising at least two glass sheets pressed on either side by at least one scattering plastic sheet or a layer of nonwoven glass fibres.

16. Light radiation-emitting panel according to Claim 15, **characterized in that** the plastic is chosen from among polyvinyl butyral, ethylene vinyl acetate copolymers and polyethylene terephthalates.

17. Light radiation-emitting panel according to any one of Claims 12 to 16, **characterized in that** the scattering structure is coincident with the reflective structure.

18. Light radiation-emitting panel according to any one of Claims 1 to 17, **characterized in that** the electronic components are light-emitting diodes or LEDs.

19. Light radiation-emitting panel according to Claim 18, **characterized in that** the LEDs are supplied with power by way of a translucent conductive layer deposited on the glass sheet of the emitting structure on which the LEDs are located.

20. Light radiation-emitting panel according to Claim 19, **characterized in that** regions have been isolated from the rest of the conductive layer through thin insulating strips.

21. Light radiation-emitting panel according to Claim 18, **characterized in that** the LEDs are supplied with power by way of a mesh of conductive wires.
